(19)

Europäisches
Patentamt
European
Patent Office
Office européen
des brevets

(11) **EP 4 607 219 A1**

(12) **EUROPEAN PATENT APPLICATION**
published in accordance with Art. 153(4) EPC

(43) Date of publication:
**27.08.2025 Bulletin 2025/35**

(21) Application number: **23880006.4**

(22) Date of filing: **01.09.2023**

(51) International Patent Classification (IPC):
*G01R 31/389* (2019.01)    *G01R 31/367* (2019.01)
*G01R 19/165* (2006.01)    *G01R 31/396* (2019.01)
*G01N 27/02* (2006.01)    *H01M 10/052* (2010.01)
*H01M 10/48* (2006.01)

(52) Cooperative Patent Classification (CPC):
**G01N 27/02; G01R 19/165; G01R 31/367;
G01R 31/389; G01R 31/396; H01M 10/052;
H01M 10/48**

(86) International application number:
**PCT/KR2023/013096**

(87) International publication number:
**WO 2024/085426 (25.04.2024 Gazette 2024/17)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **19.10.2022 KR 20220135174**

(71) Applicant: **LG Energy Solution, Ltd.
Seoul 07335 (KR)**

(72) Inventor: **KIM, Sung Won
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY MANAGEMENT DEVICE AND OPERATING METHOD THEREFOR**

(57) A battery management apparatus according to an embodiment disclosed herein includes at least one capacitor respectively connected to at least one battery and a controller configured to apply current to the at least one capacitors to pre-charge the at least one capacitors, measure a voltage of each of the at least one capacitors, and control impedance measurement of the at least one batteries based on whether the voltage of the at least one capacitors is within a threshold range.

FIG.2

EP 4 607 219 A1

# Description

## [TECHNICAL FIELD]

### CROSS-REFERENCE TO RELATED APPLICATION

This application claims priority to and the benefit of Korean Patent Application No. 10-2022-0135174 filed in the Korean Intellectual Property Office on October 19, 2022, the entire contents of which are incorporated herein by reference.

### TECHNICAL FIELD

Embodiments disclosed herein relate to a battery management apparatus and an operating method thereof.

## [BACKGROUND ART]

Recently, research and development of secondary batteries have been actively performed. Secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

To measure an impedance of the lithium ion battery, electrochemical impedance spectroscopy may be used. The electrochemical impedance spectroscopy may accurately calculate impedance which is a factor hindering electricity transmission when a chemical reaction occurs at an electrode of the battery. In a way to measure the impedance, after a precise shunt resistor is serially connected to a battery, alternating current is generated to measure voltage across opposite ends of the resistor and voltage across opposite ends of the battery to measure the impedance of the battery. When the voltage across the opposite ends of the battery is measured, + side and - side are clamped to a certain DC voltage and then a pre-charging capacitor is connected to measure the voltage. However, a conventional electrochemical impedance spectroscopy measures the impedance based on whether a specific time has elapsed, without monitoring a voltage of pre-charging capacitor connected to the battery, thereby degrading the accuracy of the impedance.

## [DISCLOSURE]

## [TECHNICAL PROBLEM]

Embodiments disclosed herein aim to provide a battery management apparatus and an operating method thereof, in which by monitoring a voltage of capacitors connected to a battery, the accuracy of an impedance of the battery measured by electrochemical impedance spectroscopy may be improved.

Technical problems of the embodiments disclosed herein are not limited to the above-described technical problems, and other unmentioned technical problems would be clearly understood by one of ordinary skill in the art from the following description.

## [TECHNICAL SOLUTION]

A battery management apparatus according to an embodiment disclosed herein includes at least one capacitor respectively connected to at least one battery and a controller configured to apply current to the at least one capacitors to pre-charge the at least one capacitors, measure a voltage of each of the at least one capacitors, and control impedance measurement of the at least one batteries based on whether the voltage of the at least one capacitors is within a threshold range.

In an embodiment, the battery management apparatus may further include at least one measurement unit configured to measure impedance of the battery, in which the at least one measurement unit may be further configured to measure the impedance of the battery based on a control signal of the controller, and the controller may be further configured to generate a control signal for measuring the impedance of the battery and transfer the control signal to the at least one measurement unit, when the voltage of each capacitor is within the threshold range.

In an embodiment, the controller may be further configured to determine whether a pre-charging time for pre-charging the at least one capacitor is greater than or equal to a threshold time, when the voltage of each capacitor is out of the threshold range.

In an embodiment, the controller may be further configured to determine whether the pre-charging time for pre-charging the capacitor is greater than or equal to the threshold time, when the voltage of each capacitor is out of the threshold range.

In an embodiment, the controller may be further configured to re-determine whether the pre-charging time is greater than or equal to the threshold time, when the voltage of each capacitor is within the threshold range.

In an embodiment, the controller may be further configured to generate an abnormality signal of the battery when re-determining, up to a threshold number of times, whether the voltage of each capacitor is within the threshold range.

In an embodiment, the controller may be further configured to pre-charge the capacitor when the pre-charging time is less than the threshold time.

An operating method of a battery management apparatus according to an embodiment disclosed herein includes applying current to a capacitor connected to a battery to pre-charge the capacitor, measuring a voltage of each capacitor, and measuring an impedance of the battery based on whether the voltage of each capacitor is within a threshold range.

In an embodiment, the measuring of the impedance of the battery based on whether the voltage of each capacitor is within a threshold range may include generating a control signal for measuring the impedance of the battery and transferring the control signal to the at least one measurement unit, when the voltage of each capacitor is within the threshold range.

In an embodiment, the measuring of the impedance of the battery based on whether the voltage of each capacitor is within a threshold range may include determining whether the pre-charging time for pre-charging the capacitor is greater than or equal to the threshold time, when the voltage of each capacitor is out of the threshold range.

In an embodiment, the operating method may further include determining whether a pre-charging time for pre-charging the capacitor is greater than or equal to a threshold time.

In an embodiment, the determining of whether the pre-charging time for pre-charging the capacitor is greater than or equal to the threshold time may include re-determining whether the pre-charging time is greater than or equal to the threshold time, when the voltage of each capacitor is within the threshold range.

In an embodiment, the determining of whether the pre-charging time for pre-charging the capacitor is greater than or equal to the threshold time may include generating an abnormality signal of the battery when re-determining, up to a threshold number of times, whether the voltage of each capacitor is within the threshold range.

In an embodiment, the determining of whether the pre-charging time for pre-charging the capacitor is greater than or equal to the threshold time may include generating a control signal for pre-charging the capacitor and transferring the control signal to the at least one capacitor, when the pre-charging time is less than the threshold time.

## [ADVANTAGEOUS EFFECTS]

A battery management apparatus and an operating method thereof according to an embodiment disclosed herein may improve the accuracy of an impedance of a battery measured by electrochemical impedance spectroscopy by monitoring a voltage of capacitors connected to the battery.

Moreover, the battery management system and the operating method thereof according to an embodiment disclosed herein may stably manage the lifespan of a battery.

## [DESCRIPTION OF DRAWINGS]

FIG. 1 is a diagram conceptually showing a battery swapping station according to an embodiment disclosed herein.

FIG. 2 is a diagram conceptually showing a battery swapping station according to another embodiment disclosed herein.

FIG. 3 is a block diagram of a battery management apparatus according to an embodiment disclosed herein.

FIG. 4 is a block diagram conceptually showing a battery pack according to an embodiment disclosed herein.

FIG. 5 is a flowchart of an operating method of a battery management apparatus according to an embodiment disclosed herein.

FIG. 6 is a flowchart showing an operating method of a battery management apparatus, according to another embodiment disclosed herein.

FIG. 7 is a block diagram showing a hardware configuration of a computing system for performing an operating method of a battery management apparatus, according to an embodiment disclosed herein.

## [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

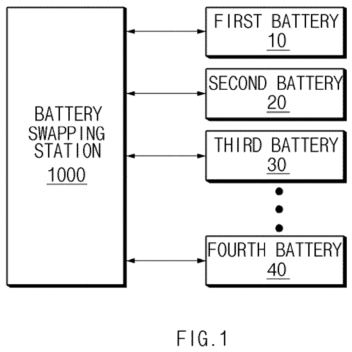

FIG. 1 is a diagram conceptually showing a battery swapping station according to an embodiment disclosed herein.

Referring to FIG. 1, a battery swapping station (BSS) 1000 may provide an overall management service for evaluation, measurement, charge, exchange, etc., of a battery, and in the present disclosure, a function of the battery swapping station 1000 will be described based on a battery swapping service. Herein, the battery swapping service may mean a service that analyzes states of a plurality of batteries 10, 20, 30, and 40 that are service subjects and swaps the batteries 10, 20, 30, and 40 with other batteries 10, 20, 30, and 40 according to an analysis result. Such swapping may be automatically performed by a manager and/or user's setting. For example, the battery swapping station 1000 may provide a user with a battery swapping service by collecting the batteries 10, 20, 30, and 40 returned from the user and providing other previously charged batteries 10, 20, 30, and 40 to the user.

Herein, the batteries 10, 20, 30, and 40 may be devices mounted on a subject device (e.g., an electrical transportation such as an electrical vehicle, an electrical scooter, an electrical bike, etc.) to supply power for driving the subject device, and may be implemented in the form of battery packs. The battery pack may include a battery that stores power and a battery management system (BMS) that controls an operation of the battery. The battery may include at least one battery cell for storing power under control of the BMS. The battery cell, which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and is not limited thereto. The BMS may control charge and discharge of the battery, and collect data that is a basis for state analysis of the battery and transmit the data to an external device at the request of the external device.

Hereinbelow, a description will be made assuming that the plurality of batteries 10, 20, 30, and 40 are implemented in the form of battery packs. While it is illustrated in FIG. 1 that the number of batteries 10, 20, 30, and 40 is 4, the batteries may include n batteries (n is a natural number greater than or equal to 2).

Depending on an embodiment, the battery swapping station 1000 may be arranged in a service station where the battery swapping service is provided or in a space that is separate from the service station.

The battery swapping station 1000 may analyze the states of the plurality of batteries 10, 20, 30, and 40 connected thereto and swap the batteries 10, 20, 30, and 40 with other batteries 10, 20, 30, and 40 or reuse (i.e., not swap) the batteries 10, 20, 30, and 40, according to a result of state analysis. The battery swapping station 1000 may autonomously determine whether state analysis with respect to the plurality of batteries 10, 20, 30, and 40 and/or swapping of the batteries 10, 20, 30, and 40 are required, but according to another embodiment, at least some operation may be performed in association with a server (e.g., a cloud server) connected through a network. For example, the battery swapping station 1000 may transmit to the cloud server, information that is a basis for determining whether swapping of a battery is required, and the cloud server may transmit to the battery swapping station 1000, the information about whether swapping of the battery is required.

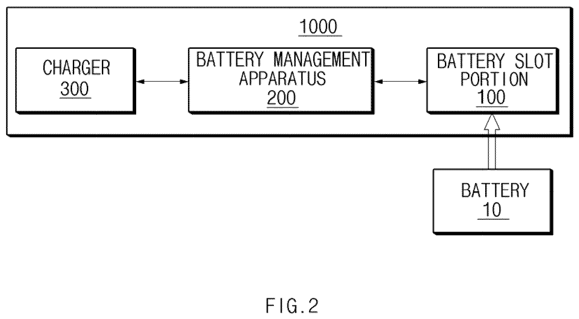

FIG. 2 is a diagram conceptually showing a battery swapping station according to another embodiment disclosed herein.

Referring to FIG. 2, the battery swapping station 1000 may include a battery slot portion 100, a battery management apparatus 200, and a charger 300.

The battery slot portion 100 may accommodate the plurality of batteries 10, 20, 30, and 40 connected. The battery slot portion 100 may include a plurality of battery slots that respectively accommodate the plurality of batteries connected. The battery slot portion 100 may be connected to the battery management apparatus 200. The plurality of batteries 10, 20, 30, and 40 accommodated in the battery slot portion 100 may be physically controlled based on a control signal of the battery management apparatus 200.

The battery management apparatus 200 may manage and/or control a state and/or an operation of the plurality of batteries 10, 20, 30, and 40. The battery management apparatus 200 may manage charge and/or discharge of the plurality of batteries 10, 20, 30, and 40.

In addition, the battery management apparatus 200 may monitor a voltage, a current, a temperature, etc., of each of the plurality of batteries 10, 20, 30, and 40. The battery management apparatus 200 may calculate parameters indicating the states of the plurality of batteries 10, 20, 30, and 40 based on measurement values of the monitored voltage, current, temperature, etc.

The battery management apparatus 200 may manage a state of charge (SoC) and/or a state of health (SoH) of the plurality of batteries 10, 20, 30, and 40. The battery management apparatus 200 may receive SoC information of each of the plurality of batteries 10, 20, 30, and 40 from the corresponding batteries 10, 20, 30, and 40. Herein, the SoC information may indicate a current SoC of the corresponding battery and the SoC may mean a charge state of a battery included in the battery, i.e., a remaining capacity rate.

A battery management apparatus for the corresponding battery may calculate the remaining capacity rate by dividing the current available capacity of the battery by a total capacity of the battery. For example, the remaining capacity rate may be calculated as a percentage. According to another embodiment, the battery management apparatus 200 may obtain SoC information by directly calculating a remaining capacity rate for a battery without receiving the SoC information from the BMS for the battery.

The charger 300 may charge each of the plurality of batteries 10, 20, 30, and 40 under control of the battery management apparatus 200. The charger 300 may be supplied with power from an external utility power source to convert the power into a power form that may be received by the plurality of batteries 10, 20, 30, and 40, and supply the power to the plurality of batteries 10, 20, 30, and 40. According to an embodiment, the charger 300 may supply power until the SoCs of the plurality of batteries 10, 20, 30, and 40 reach 100 %, thus fully charging the plurality of batteries 10, 20, 30, and 40.

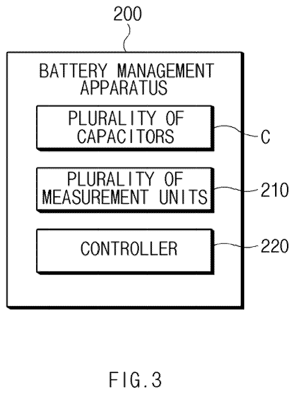

Hereinbelow, a configuration and an operation of the battery management apparatus 200 will be described in more detail with reference to FIG. 3.

FIG. 3 is a block diagram of a battery management apparatus according to an embodiment disclosed herein.

Referring to FIG. 3, the battery management apparatus 200 may include a plurality of capacitors C, a plurality of measurement units 210, and a controller 230.

The battery management apparatus 200 may measure alternating current impedances of the plurality of batteries 10, 20, 30, and 40. For example, the battery management apparatus 200 may measure alternating current impedances of the plurality of batteries 10, 20, 30, and 40 by using electrochemical impedance spectroscopy. The electrochemical impedance spectroscopy may detect impedance which is a factor hindering electricity transmission when a chemical reaction occurs at electrodes of the plurality of batteries 10, 20, 30, and 40. The battery management apparatus 200 may measure alternating current impedances of the plurality of batteries 10, 20, 30, and 40 with a non-destructive testing method by using electrochemical impedance spectroscopy.

When measuring the alternating current impedances of the plurality of batteries 10, 20, 30, and 40, the battery management apparatus 200 may generate direct current voltage DC by connecting a capacitor C to the battery to prevent overcurrent generated at the early driving of the plurality of plurality of batteries 10, 20, 30, and 40, that is, inrush current. Herein, generation of the direct current voltage DC in the capacitor C by connecting the capacitor C to the battery by the battery management apparatus 200 may be defined as pre-charging, or voltage charged in the capacitor C may be defined as pre-charging voltage.

Each of a plurality of capacitors C may be electrically connected to opposite ends of at least one of the plurality of batteries 10, 20, 30, and 40. Each of the plurality of capacitors C may be charged by being supplied with current from the charger 300. A time for generating direct current voltage by supplying current to the plurality of capacitors C may be referred to as a pre-charging time.

The plurality of measurement units 210 may measure impedances of the plurality of batteries 10, 20, 30, and 40 electrically connected respectively to the plurality of capacitors C.

For example, when the battery swapping station 1000 includes 8 battery slots, the plurality of measurement units 210 may be implemented with one measurement unit 210, and the measurement unit 210 may measure impedances of 8 batteries respectively inserted into the 8 battery slots.

For example, when the battery swapping station 1000 includes 8 battery slots, the plurality of measurement units 210 may be implemented with two measurement units 210, and each of the two measurement units 210 may measure impedances of 4 batteries respectively inserted into 4 battery slots.

Each of the plurality of measurement units 210 may be electrically connected to any one of the plurality of capacitors C.

For example, when the battery swapping station 1000 includes 8 battery slots, the plurality of measurement units 210 may be implemented with one measurement unit 210, and the measurement unit 210 may be electrically connected to 8 capacitors connected to 8 batteries.

For example, when the battery swapping station 1000 includes 8 battery slots, the plurality of measurement units 210 may be implemented with two measurement units 210, and each of the two measurement units 210 may be electrically connected to 4 capacitors connected to 4 batteries.

Each of the plurality of measurement units 210 may measure impedances of the plurality of batteries 10, 20, 30, and 40 based on a control signal of the controller 220. The plurality of measurement units 210 may measure impedances of the plurality of batteries 10, 20, 30, and 40 by using electrochemical impedance spectroscopy (EIS).

The plurality of measurement units 210 may calculate alternating current impedance spectrums of the plurality of batteries 10, 20, 30, and 40 based on a change in amplitude and phase of a signal detected from the plurality of batteries 10, 20, 30, and 40 with respect to a change in frequency of alternating current (AC) power applied to the plurality of batteries 10, 20, 30, and 40.

The controller 220 may pre-charge the plurality of capacitors C by applying alternating current to the plurality of capacitors C. The controller 220 may measure a voltage of each of the plurality of capacitors C.

For example, the controller 220 may obtain a voltage of each of the plurality of capacitors C from an analog-to-digital converter (ADC) that converts a voltage of each of the plurality of capacitors C into a digital signal.

The controller 220 may determine whether the voltages of the plurality of capacitors C are within a threshold range. The controller 220 may control impedance measurement of the plurality of batteries 10, 20, 30, and 40 by the plurality of measurement units 210 based on the voltages of the plurality of capacitors C being within the threshold range. For example, the controller 220 may determine whether the voltage of each of the plurality of capacitors C is within a threshold range of $1.8 \text{ V} \pm 5 \%$.

When the voltage of each of the plurality of capacitors C is within the threshold range, the controller 220 may generate a control signal for measuring the impedances of the plurality of batteries 10, 20, 30, and 40 and transfer the control signal to the plurality of measurement unit 210.

The controller 220 may determine whether the pre-charging time for pre-charging the plurality of capacitors C is greater than or equal to the threshold time, when the voltage of each of the plurality of capacitors C is out of the threshold range. For example, the controller 220 may determine whether the pre-charging time of the plurality of capacitors C is greater than or equal to a threshold time of 4000 ms, when the voltage of each of the plurality of capacitors C is out of a threshold range of 1.8 V ± 5 %.

When the pre-charging time is greater than or equal to the threshold time, the controller 220 may re-determine whether the voltage of each of the plurality of capacitors C is within the threshold range after the elapse of a specific time. The controller 220 may redetermine, up to a threshold number of times, whether the voltages of the plurality of capacitors C are within the threshold range.

The controller 220 may generate abnormality signals of the plurality of batteries 10, 20, 30, and 40 when re-determining, up to the threshold number of times, whether the voltage of each capacitor C is within the threshold range. For example, the controller 220 may generate an abnormality signal when redetermining whether the voltage of each of the plurality of capacitors C is within the threshold range three times that are the threshold number of times.

The controller 220 may continue pre-charging the plurality of capacitors C when the pre-charging time is less than the threshold time. For example, the controller 220 may continue pre-charging the capacitor C until the remaining time T_remain when the pre-charging time is less than the threshold time. Herein, the remaining time T_remain will be described with reference to [Equation 1] below.

[Equation 1]

$$T_{remain} = \alpha(V_{max} - V_{adc}) * \left( \frac{T_{adc}}{V_{adc} - V_{init}} \right)$$

Herein, a may mean an environment variable, i.e., a feature value of the capacitor C. V_max may be a maximum charging voltage of the capacitor C, e.g., 1.8 V. V_adc may mean a voltage of each capacitor C, obtained from an analog-to-digital converter. Herein, T_adc may mean a pre-charging time for pre-charging the plurality of capacitors C. V_init may mean the voltages of the plurality of capacitors C when pre-charging starts.

The controller 220 may calculate the remaining time T_remain based on [Equation 1], and continue pre-charging the plurality of capacitors C during the remaining time T_remain.

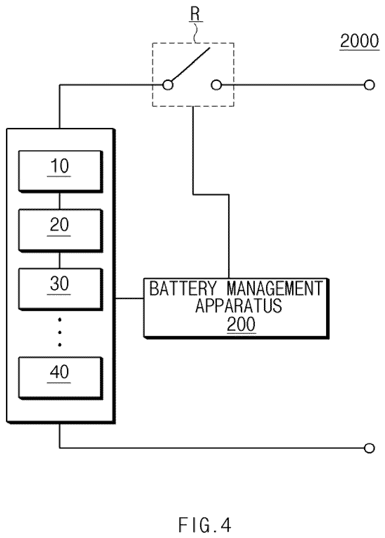

FIG. 4 is a block diagram conceptually showing a battery pack of a vehicle battery system, according to an embodiment disclosed herein.

Referring to FIG. 4, a battery pack 2000 according to an embodiment disclosed herein may include a plurality of battery modules M1, M2, M3, and M4, the battery management apparatus 200, and a relay R.

According to an embodiment, the battery management apparatus 200 may be implemented with a battery management apparatus of a vehicle battery system.

The plurality of battery modules M1, M2, M3, and M4 of the vehicle battery system may include a plurality of battery cells. Although the plurality of battery modules M1, M2, M3, and M4 are illustrated as four in FIG. 4, the present disclosure is not limited thereto, and the plurality of battery modules M1, M2, M3, and M4 may include n battery cells (n is a natural number equal to or greater than 2).

The battery management apparatus 200 of the vehicle battery system may manage and/or control a state and/or an operation of the plurality of battery modules M1, M2, M3, and M4. For example, the battery management apparatus 200 may manage and/or control the states and/or operations of a plurality of battery cells included in the plurality of battery modules M1, M2, M3, and M4. The battery management apparatus 200 may manage charging and/or discharging of the plurality of battery modules M1, M2, M3, and M4.

The battery management apparatus 200 may monitor a voltage, a current, a temperature, etc., of each of the plurality of battery modules M1, M2, M3, and M4 and/or each of the plurality of battery cells included in the plurality of battery modules M1, M2, M3, and M4. A sensor or various measurement modules for monitoring performed by the battery management apparatus 200, which are not shown, may be additionally installed in the plurality of battery modules M1, M2, M3, and M4, a charging/discharging path, any position of the plurality of battery modules M1, M2, M3, and M4, etc.

The battery management apparatus 200 may control an operation of the relay R. For example, the battery management apparatus 200 may short-circuit the relay R to supply power to a target device. The battery management apparatus 200 may short-circuit the relay R when a charging device is connected to the battery pack 2000.

The alternating current impedances of the plurality of battery modules M1, M2, M3, and M4 may be measured. For example, the battery management apparatus 200 may measure alternating current impedances of the plurality of battery modules M1, M2, M3, and M4 by using electrochemical impedance spectroscopy.

Each of the plurality of capacitors C may be electrically connected to opposite ends of at least one of the plurality of battery modules M1, M2, M3, and M4. The plurality of measurement units 210 may measure impedances of the plurality of battery modules M1, M2, M3, and M4 electrically connected respectively to the plurality of capacitors C. Each of the plurality of measurement units 210 may be electrically connected to any one of the plurality of capacitors C. Each of the plurality of measurement units 210 may measure the impedances of the plurality of battery modules M1, M2, M3, and M4 based on the control signal of the controller 220.

The controller 220 may pre-charge the plurality of capacitors C by applying alternating current to the plurality of capacitors C. The controller 220 may measure a voltage of each of the plurality of capacitors C. For example, the controller 220 may obtain a voltage of each of the plurality of capacitors C from an analog-to-digital converter (ADC) that converts a voltage of each of the plurality of capacitors C into a digital signal.

The controller 220 may determine whether the voltages of the plurality of capacitors C are within a threshold range. The controller 220 may control impedance measurement of the plurality of battery modules M1, M2, M3, and M4 by the plurality of measurement units 210 based on the voltages of the plurality of capacitors C being within the threshold range.

According to an embodiment, the battery management apparatus 200 may be connected to outside of a battery management apparatus of an existing vehicle battery system to measure the impedances of the plurality of battery modules M1, M2, M3, and M4 through communication with the battery management apparatus of the vehicle battery system.

As described above, the battery management apparatus according to an embodiment disclosed herein may monitor voltages of capacitors connected to the battery to improve the accuracy of the impedance, measured using electrochemical impedance spectroscopy, of the battery.

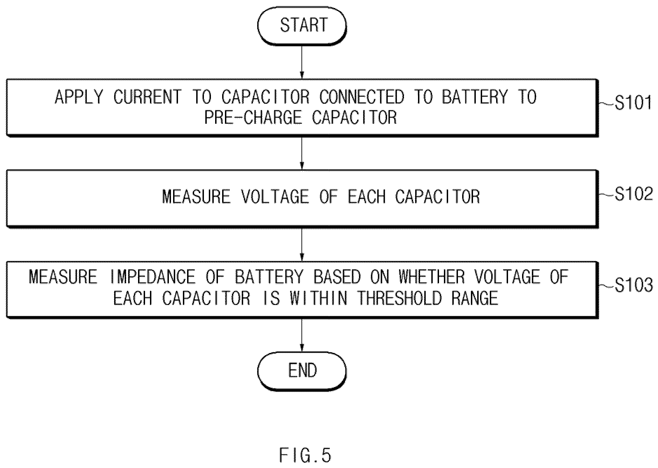

FIG. 5 is a flowchart of an operating method of a battery management apparatus according to an embodiment disclosed herein.

Referring to FIG. 5, an operating method of a battery management apparatus according to an embodiment disclosed herein includes operation S 101 of apply current to a plurality of capacitors connected to a plurality of batteries to pre-charge the plurality of capacitors, operation S102 of measuring voltage of each of the plurality of capacitors, and operation S103 of measuring impedances of the plurality of batteries based on whether the voltage of each of the plurality of capacitors is within a threshold range.

Hereinbelow, operations S101 through S103 will be described in detail with reference to FIGS. 1 and 4. The battery management apparatus 200 may be substantially the same as the battery management apparatus 200 described with reference to FIGS. 1 to 4, and thus will be briefly described to avoid redundant description.

In operation S101, each of a plurality of capacitors C may be electrically connected to opposite ends of at least one of the plurality of batteries 10, 20, 30, and 40.

In operation S101, the controller 220 may pre-charge the plurality of capacitors C by applying alternating current to the plurality of capacitors C.

In operation S102, the controller 220 may measure a voltage of each of the plurality of capacitors C. In operation S102, for example, the controller 220 may obtain a voltage of each of the plurality of capacitors C from an analog-to-digital converter (ADC) that converts a voltage of each of the plurality of capacitors C into a digital signal.

In operation S103, the controller 220 may determine whether the voltages of the plurality of capacitors C are within a threshold range. In operation S103, the controller 220 may control impedance measurement of the plurality of batteries 10, 20, 30, and 40 by the plurality of measurement units 210 based on the voltages of the plurality of capacitors C being within the threshold range. In operation S103, for example, the controller 220 may determine whether the voltage of each of the plurality of capacitors C is within a threshold range of 1.8 V ± 5 %.

In operation S103, when the voltage of each of the plurality of capacitors C is within the threshold range, the controller 220 may generate a control signal for measuring the impedances of the plurality of batteries 10, 20, 30, and 40 and transfer the control signal to the plurality of measurement unit 210.

In operation S103, each of the plurality of measurement units 210 may measure impedances of the plurality of batteries 10, 20, 30, and 40 based on a control signal of the controller 220. In operation S103, the plurality of measurement units 210 may measure impedances of the plurality of batteries 10, 20, 30, and 40 by using electrochemical impedance spectroscopy (EIS).

In operation S103, the plurality of measurement units 210 may calculate alternating current impedance spectrums of the plurality of batteries 10, 20, 30, and 40 based on a change in amplitude and phase of a signal detected from the plurality of batteries 10, 20, 30, and 40 with respect to a change in frequency of alternating current (AC) power applied to the plurality of batteries 10, 20, 30, and 40.

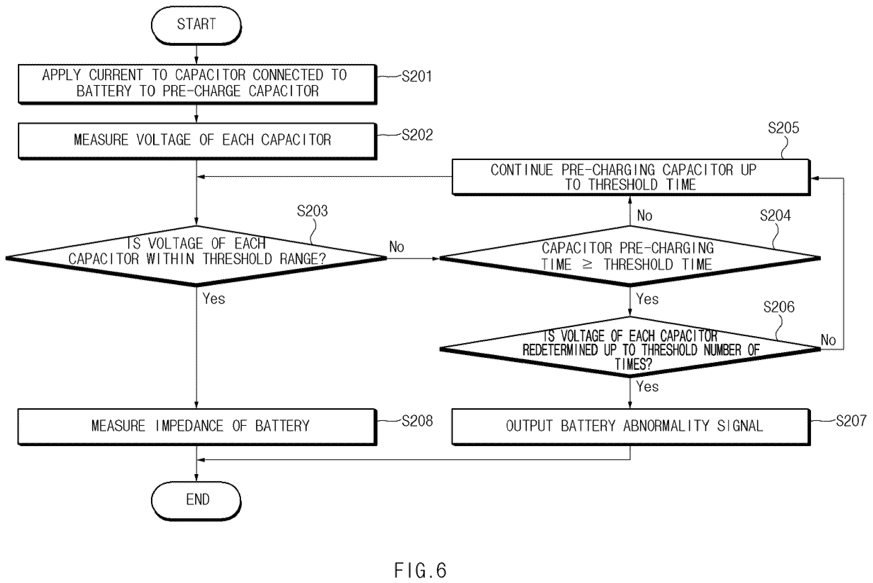

FIG. 6 is a flowchart showing an operating method of a battery management apparatus, according to another embodiment disclosed herein.

Referring to FIG. 6, an operating method of a battery management apparatus according to an embodiment disclosed herein includes operation S201 of applying current to a plurality of capacitors connected to a plurality of batteries to pre-charge the plurality of capacitors, operation S202 of measuring a voltage of each of the plurality of capacitors, operation S203 of determining whether the voltage of each of the plurality of capacitors is within a threshold range, operation S204 of determining whether a pre-charging time for the plurality of capacitors is within a threshold time, operation S205 of continue pre-charging the plurality of capacitors up to the threshold time, operation S206 of re-determining, up to a threshold number of times, whether the voltage of each of the plurality of capacitors is within a threshold range, operation S207 of outputting a battery abnormality signal, and operation S208 of measuring an impedance of the battery.

Hereinbelow, operations S201 through S208 will be described in detail with reference to FIGS. 1 and 4. The battery management apparatus 200 may be substantially the same as the battery management apparatus 200 described with reference to FIGS. 1 to 4, and thus will be briefly described to avoid redundant description.

In operation S201, each of a plurality of capacitors C may be electrically connected to opposite ends of at least one of the plurality of batteries 10, 20, 30, and 40.

In operation S201, the controller 220 may pre-charge the plurality of capacitors C by applying alternating current to the plurality of capacitors C.

In operation S202, the controller 220 may measure a voltage of each of the plurality of capacitors C. In operation S202, for example, the controller 220 may obtain a voltage of each of the plurality of capacitors C from an analog-to-digital converter (ADC) that converts a voltage of each of the plurality of capacitors C into a digital signal.

In operation S203, the controller 220 may determine whether the voltages of the plurality of capacitors C are within a threshold range. In operation S203, the controller 220 may control impedance measurement of the plurality of batteries 10, 20, 30, and 40 by the plurality of measurement units 210 based on the voltages of the plurality of capacitors C being within the threshold range. In operation S203, for example, the controller 220 may determine whether the voltage of each of the plurality of capacitors C is within a threshold range of 1.8 V ± 5 %.

In operation S204, the controller 220 may determine whether the pre-charging time for pre-charging the plurality of capacitors C is greater than or equal to the threshold time, when the voltage of each of the plurality of capacitors C is out of the threshold range. In operation S204, for example, the controller 220 may determine whether the pre-charging time of the plurality of capacitors C is greater than or equal to a threshold time of 4000 ms, when the voltage of each of the plurality of capacitors C is out of a threshold range of 1.8 V ± 5 %.

In operation S205, the controller 220 may continue pre-charging the plurality of capacitors C when the pre-charging time is less than the threshold time. In operation S205, for example, the controller 220 may continue pre-charging the capacitor C until the remaining time T_remain when the pre-charging time is less than the threshold time. Herein, the remaining time T_remain will be described with reference to [Equation 1] below.

[Equation 1]

$$T_{remain} = \alpha(V_{max} - V_{adc}) * \left( \frac{T_{adc}}{V_{adc} - V_{init}} \right)$$

Herein, a may mean an environment variable, i.e., a feature value of the capacitor C. V_max may be a maximum charging voltage of the capacitor C, e.g., 1.8 V. V_adc may mean a voltage of each capacitor C, obtained from an analog-to-digital converter. Herein, T_adc may mean a pre-charging time for pre-charging the plurality of capacitors C. V_init may mean the voltages of the plurality of capacitors C when pre-charging starts.

In operation S205, the controller 220 may calculate the remaining time T_remain based on [Equation 1], and continue pre-charging the plurality of capacitors C during the remaining time T_remain.

In operation S206, when the pre-charging time is greater than or equal to the threshold time, the controller 220 may re-determine whether the voltage of each of the plurality of capacitors C is within the threshold range after the elapse of a specific time. In operation S206, the controller 220 may redetermine, up to a threshold number of times, whether the voltages of the plurality of capacitors C are within the threshold range.

In operation S207, the controller 220 may generate abnormality signals of the plurality of batteries 10, 20, 30, and 40 when re-determining, up to the threshold number of times, whether the voltage of each capacitor C is within the threshold range. In operation S207, for example, the controller 220 may generate an abnormality signal when redetermining whether the voltage of each of the plurality of capacitors C is within the threshold range three times that are the threshold number of times.

In operation S208, when the voltage of each of the plurality of capacitors C is within the threshold range, the controller 220 may generate a control signal for measuring the impedances of the plurality of batteries 10, 20, 30, and 40 and transfer the control signal to the plurality of measurement unit 210.

In operation S208, each of the plurality of measurement units 210 may measure impedances of the plurality of batteries 10, 20, 30, and 40 based on a control signal of the controller 220. In operation S208, the plurality of measurement units 210 may measure impedances of the plurality of batteries 10, 20, 30, and 40 by using electrochemical impedance spectroscopy (EIS).

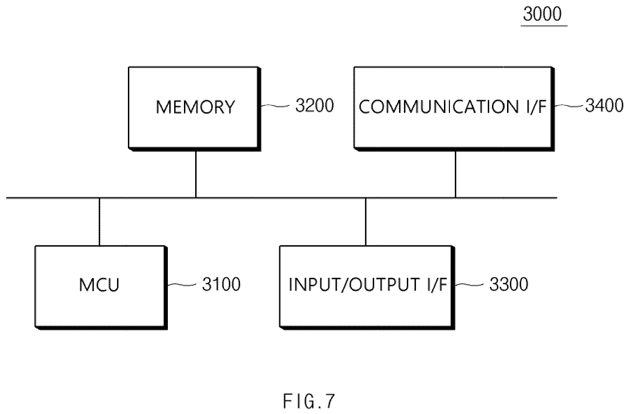

FIG. 7 is a block diagram showing a hardware configuration of a computing system for performing an operating method of a battery management apparatus, according to an embodiment disclosed herein.

Referring to FIG. 7, a computing system 3000 according to an embodiment disclosed herein may include an MCU 3100, a memory 3200, an input/output I/F 3300, and a communication I/F 3400.

The MCU 3100 may be a processor that executes various programs (e.g., a capacitor voltage calculation program) stored in the memory 3200, processes various data including an SOC, an SOH, etc., of a plurality of battery cells through these programs, executes functions of the battery management apparatus 200 described above with reference to FIG. 1, or executes the operating method of the battery management apparatus described with reference to FIG. 4.

The memory 3200 may store various programs related to impedance calculation of the plurality of batteries. Moreover, the memory 3200 may store various data such as SOC data, SOH data, etc., of each battery.

The memory 3200 may be provided in plural, depending on a need. The memory 3200 may be volatile memory or non-volatile memory. For the memory 3200 as the volatile memory, random access memory (RAM), dynamic RAM (DRAM), static RAM (SRAM), etc., may be used. For the memory 3200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 3200 are merely examples and are not limited thereto.

The input/output I/F 3300 may provide an interface for transmitting and receiving data by connecting an input device (not shown) such as a keyboard, a mouse, a touch panel, etc., and an output device such as a display (not shown), etc., to the MCU 3100.

The communication I/F 3300, which is a component capable of transmitting and receiving various data to and from a server, may be various devices capable of supporting wired or wireless communication. For example, a program for SOH calculation of the battery cell or target determination or various data, etc., may be transmitted and received to and from a separately provided external server through the communication I/F 3300.

As such, an operating method of a battery management apparatus according to an embodiment disclosed herein may be recorded in the memory 3200 and executed by the MCU 3100.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

[Explanation of Reference Numerals]

    10, 20, 30, 40: Plurality of Batteries
    1000: Battery Swapping Station
    100: Battery Slot Portion
    200: Battery Management Apparatus
    C: Capacitor
    210: Measurement Unit
    220: Controller
    300: Charger
    2000: Battery Pack
    R: Relay
    M1, M2, M3, M4: Battery Module
    3000: Computing System
    3100: MCU
    3200: Memory
    3300: Input/Output I/F
    3400: Communication I/F

## Claims

1. A battery management apparatus comprising:

   at least one capacitors respectively connected to at least one battery; and
   a controller configured to apply current to the at least one capacitors to pre-charge the at least one capacitors, measure a voltage of each of the at least one capacitors, and control impedance measurement of the at least one batteries based on whether the voltage of the at least one capacitors is within a threshold range.

2. The battery management apparatus of claim 1, further comprising at least one measurement unit configured to measure impedance of the battery,

   wherein the at least one measurement unit is further configured to measure the impedance of the battery based on a control signal of the controller, and
   the controller is further configured to generate a control signal for measuring the impedance of the battery and transfer the control signal to the at least one measurement unit, when the voltage of each capacitor is within the threshold range.

3. The battery management apparatus of claim 1, wherein the controller is further configured to determine whether a pre-charging time for pre-charging the at least one capacitor is greater than or equal to a threshold time, when the voltage of each capacitor is out of the threshold range.

**4.** The battery management apparatus of claim 3, wherein the controller is further configured to determine whether the pre-charging time for pre-charging the capacitor is greater than or equal to the threshold time, when the voltage of each capacitor is out of the threshold range.

**5.** The battery management apparatus of claim 4, wherein the controller is further configured to re-determine whether the pre-charging time is greater than or equal to the threshold time, when the voltage of each capacitor is within the threshold range.

**6.** The battery management apparatus of claim 5, wherein the controller is further configured to generate an abnormality signal of the battery when re-determining, up to a threshold number of times, whether the voltage of each capacitor is within the threshold range.

**7.** The battery management apparatus of claim 4, wherein the controller is further configured to pre-charge the capacitor when the pre-charging time is less than the threshold time.

**8.** An operating method of a battery management apparatus, the operating method comprising:

applying current to a capacitor connected to a battery to pre-charge the capacitor;
measuring a voltage of each capacitor; and
measuring an impedance of the battery based on whether the voltage of each capacitor is within a threshold range.

**9.** The operating method of claim 8, wherein the measuring of the impedance of the battery based on whether the voltage of each capacitor is within a threshold range comprises generating a control signal for measuring the impedance of the battery and transferring the control signal to the at least one measurement unit, when the voltage of each capacitor is within the threshold range.

**10.** The operating method of claim 8, wherein the measuring of the impedance of the battery based on whether the voltage of each capacitor is within a threshold range comprises determining whether the pre-charging time for pre-charging the capacitor is greater than or equal to the threshold time, when the voltage of each capacitor is out of the threshold range.

**11.** The operating method of claim 10, further comprising determining whether a pre-charging time for pre-charging the capacitor is greater than or equal to a threshold time.

**12.** The operating method of claim 11, wherein the determining of whether the pre-charging time for pre-charging the capacitor is greater than or equal to the threshold time comprises re-determining whether the pre-charging time is greater than or equal to the threshold time, when the voltage of each capacitor is within the threshold range.

**13.** The operating method of claim 12, wherein the determining of whether the pre-charging time for pre-charging the capacitor is greater than or equal to the threshold time comprises generating an abnormality signal of the battery when re-determining, up to a threshold number of times, whether the voltage of each capacitor is within the threshold range.

**14.** The operating method of claim 11, wherein the determining of whether the pre-charging time for pre-charging the capacitor is greater than or equal to the threshold time comprises generating a control signal for pre-charging the capacitor and transferring the control signal to the at least one capacitor, when the pre-charging time is less than the threshold time.

FIG.1

1000

CHARGER
300

BATTERY MANAGEMENT
APPARATUS
200

BATTERY SLOT
PORTION
100

BATTERY
10

FIG.2

200

BATTERY MANAGEMENT
APPARATUS

PLURALITY OF
CAPACITORS — C

PLURALITY OF
MEASUREMENT UNITS — 210

CONTROLLER — 220

FIG.3

R

2000

10

20

30

40

BATTERY MANAGEMENT
APPARATUS
200

FIG.4

START

APPLY CURRENT TO CAPACITOR CONNECTED TO BATTERY TO
PRE-CHARGE CAPACITOR — S101

MEASURE VOLTAGE OF EACH CAPACITOR — S102

MEASURE IMPEDANCE OF BATTERY BASED ON WHETHER VOLTAGE OF
EACH CAPACITOR IS WITHIN THRESHOLD RANGE — S103

END

FIG.5

START

APPLY CURRENT TO CAPACITOR CONNECTED TO
BATTERY TO PRE-CHARGE CAPACITOR — S201

MEASURE VOLTAGE OF EACH CAPACITOR — S202

CONTINUE PRE-CHARGING CAPACITOR UP
TO THRESHOLD TIME — S205

IS VOLTAGE OF EACH
CAPACITOR WITHIN THRESHOLD RANGE? — S203

No

No — S204

CAPACITOR PRE-CHARGING
TIME ≥ THRESHOLD TIME

Yes

Yes

IS VOLTAGE OF EACH CAPACITOR
REDETERMINED UP TO THRESHOLD NUMBER OF
TIMES? — S206

No

MEASURE IMPEDANCE OF BATTERY — S208

OUTPUT BATTERY ABNORMALITY SIGNAL — S207

Yes

END

FIG.6

3000

MEMORY —— 3200    COMMUNICATION I/F —3400

MCU —— 3100    INPUT/OUTPUT I/F —— 3300

FIG.7

**INTERNATIONAL SEARCH REPORT**

| International application No. |
| --- |
| **PCT/KR2023/013096** |

**A. CLASSIFICATION OF SUBJECT MATTER**

**G01R 31/389**(2019.01)i; **G01R 31/367**(2019.01)i; **G01R 19/165**(2006.01)i; **G01R 31/396**(2019.01)i; **G01N 27/02**(2006.01)i; **H01M 10/052**(2010.01)i; **H01M 10/48**(2006.01)i

According to International Patent Classification (IPC) or to both national classification and IPC

**B. FIELDS SEARCHED**

Minimum documentation searched (classification system followed by classification symbols)

G01R 31/389(2019.01); G01R 31/3842(2019.01); H01M 10/44(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 프리차징(Pre-charging), 전지(battery), 전류(current), 전압(voltage), 임피던스(impedance), 커패시터(capacitor), 스위치(switch)

**C. DOCUMENTS CONSIDERED TO BE RELEVANT**

| Category* | Citation of document, with indication, where appropriate, of the relevant passages | Relevant to claim No. |
| --- | --- | --- |
| Y | KR 10-2021-0070077 A (LG ENERGY SOLUTION, LTD.) 14 June 2021 (2021-06-14)<br>See paragraphs [0080]-[0093], claims 1-2 and figures 1-3. | 1-14 |
| Y | KR 10-2367775 B1 (UNIVERSITY OF ULSAN FOUNDATION FOR INDUSTRY COOPERATION) 24 February 2022 (2022-02-24)<br>See paragraphs [0020]-[0031] and figures 1-2c. | 1-14 |
| A | KR 10-2021-0101136 A (SAMSUNG SDI CO., LTD.) 18 August 2021 (2021-08-18)<br>See claims 1-10. | 1-14 |
| A | KR 10-2255523 B1 (LG ENERGY SOLUTION, LTD.) 25 May 2021 (2021-05-25)<br>See claims 1 and 6. | 1-14 |
| A | US 2004-0073264 A1 (LYDEN, Michael J.) 15 April 2004 (2004-04-15)<br>See entire document. | 1-14 |

☐ Further documents are listed in the continuation of Box C.  ☑ See patent family annex.

| | | |
| --- | --- | --- |
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| **08 December 2023** | **11 December 2023** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2023/013096**

| Patent document cited in search report | | | Publication date (day/month/year) | Patent family member(s) | | | Publication date (day/month/year) |
|---|---|---|---|---|---|---|---|
| KR | 10-2021-0070077 | A | 14 June 2021 | CN | 114051684 | A | 15 February 2022 |
| | | | | EP | 4002638 | A1 | 25 May 2022 |
| | | | | EP | 4002638 | A4 | 26 April 2023 |
| | | | | JP | 2022-540997 | A | 21 September 2022 |
| | | | | JP | 7342237 | B2 | 11 September 2023 |
| | | | | US | 2022-0294249 | A1 | 15 September 2022 |
| | | | | WO | 2021-112459 | A1 | 10 June 2021 |
| KR | 10-2367775 | B1 | 24 February 2022 | | None | | |
| KR | 10-2021-0101136 | A | 18 August 2021 | CN | 113212242 | A | 06 August 2021 |
| | | | | EP | 3863103 | A1 | 11 August 2021 |
| | | | | US | 2021-0245625 | A1 | 12 August 2021 |
| KR | 10-2255523 | B1 | 25 May 2021 | KR | 10-2017-0138140 | A | 15 December 2017 |
| US | 2004-0073264 | A1 | 15 April 2004 | CA | 2303095 | A1 | 25 March 1999 |
| | | | | EP | 1019742 | A1 | 19 July 2000 |
| | | | | US | 2001-0034541 | A1 | 25 October 2001 |
| | | | | US | 2002-0140404 | A1 | 03 October 2002 |
| | | | | US | 2004-0024426 | A1 | 05 February 2004 |
| | | | | US | 2007-0265672 | A1 | 15 November 2007 |
| | | | | US | 6167309 | A | 26 December 2000 |
| | | | | US | 6631293 | B2 | 07 October 2003 |
| | | | | US | 6654640 | B2 | 25 November 2003 |
| | | | | US | 7251527 | B2 | 31 July 2007 |
| | | | | US | 7515962 | B2 | 07 April 2009 |
| | | | | US | 7580749 | B2 | 25 August 2009 |
| | | | | WO | 99-14612 | A1 | 25 March 1999 |

Form PCT/ISA/210 (patent family annex) (July 2022)

**REFERENCES CITED IN THE DESCRIPTION**

**Patent documents cited in the description**

- KR 1020220135174